# EUROPEAN PATENT APPLICATION

(11) **EP 2 242 156 A1**
(43) Date of publication of application: **20.10.2010**
(21) Application number: 10159955.3
(22) Date of filing: 14.04.2010
(51) Int. Cl.: H02G 1/14, H02G 3/08, H05K 5/06

(54) **Installation kit and method for the waterproof installation of an electrical element**

(30) Priority: 15.04.2009 BE 200900235
(71) Applicant: NIKO, N.V., 9100 Sint-Niklaas (BE)
(72) Inventor: Verhaeghe, Niels Jan, 9070, Destelbergen (BE)
(74) Representative: Van Ballaer, Evi Maria August

(57) **Abstract**

An installation kit for making an electrical element (300) watertight. The installation kit comprises a container (100, 200, 500) suitable to contain a sealing compound (600), for submerging the electrical element (300). The container (100, 200, 500) comprises a basic section (101, 201, 501) for holding the electrical element (300), and at least two protuberances (102, 103; 202, 203; 502, 503) along opposing sides of the basic section (101, 201, 501) for holding wiring (301, 302) to the electrical element (300). The basic section (101, 201, 501) and protuberances (102, 103; 202, 203; 502, 503) provide a stable base for the container (100, 200, 500). Optionally, the installation kit further comprises a packaging unit (504) having an insert (505) with cutout (506) for the container (100, 200, 500).

## Description

### Field of the Invention

This invention relates to an installation kit intended to make an electrical element, such as a transformer for garden lighting or a power supply unit for LED lighting, watertight and/or dustproof, and to the installation method in which this type of installation kit is used. Making an electrical element watertight and dustproof is important when the electrical element is used outdoors, for example for subterranean applications such as flower beds, ponds, swimming pools, garden paths, carports, drives, etc. Specifications relating to the watertight and dustproof making of an electrical element are given in e.g. the international protection standard IEC 60529.

### Background of the Invention

Two types of solutions are available to make an electrical element, such as a transformer, watertight.

The first type of solution uses a pre-assembled watertight, sealed housing and glands to connect the wiring to the electrical element. A typical example of the above is described in the European patent application EP 1 650 775 entitled "Water-tight Multiple Junction Box for an Electronic Transformer". Other examples can be found in US 2004/0075989 entitled "Electrical Device with Water-Tight Housing and Method of Making Same", and CA 654463 entitled "Waterproof Transformer Seal and Method of Making Same".

The known solution based on a sealed housing in which a protective thermoplast, rubber or silicon solution may be poured into, and glands for the connection of the wiring, has several disadvantages. This solution is complex and expensive to manufacture because more and more expensive components are used, e.g. glands or specific connectors, and also because the watertight seal has to be created during the manufacturing process. Furthermore, this known solution also imposes limitations with respect to the applied wiring. The electrical element can only be connected with wiring of a previously defined diameter and/or type. The use of other wiring requires a version with other glands and connectors. This first type of watertight electrical element is neither user friendly nor flexible for the installer who has to connect the wiring.

With the second type of solution, the electrical element is encapsulated at the installation site in a resinous solution, which hardens completely after a specific drying time and thus becomes waterproof.

To encapsulate the electrical element with its wiring in resin, installers traditionally use a rectangular or cylinder shaped container, which is available from wholesalers. The container is typically oversized to the extent that the electrical element and its wiring can easily be mounted within the container. Once the rectangular container is filled with resin, the transformer with wiring is submerged within the resin.

This second known employed solution based on the use of a rectangular container has the disadvantage that the rectangular container is not stable and easily overturns during installation or during the drying period. Particularly when several transformers are interconnected, for example to create lighting alongside an outdoor pool or garden path, there is a real risk of several containers overturning when one of the transformers or their wiring is touched. This results in the resin flowing out of the container so that the installer has to partly, or completely, repeat the installation procedure.

Another disadvantage of the known solution involving a rectangular container is that the existing containers do not indicate how much resin solution needs to be injected into the container in order to make a specific electrical element watertight. This often leads to the resin solution overflowing from the container when the transformer is submerged.

Because the shape of the container is not adapted to the electrical element, too much resin will frequently be poured into the container, more than necessary to make the transformer watertight. In view of the fact that resin is an expensive and not very environmentally friendly material, production and/or installation costs will be high when the current solution based on resin in a rectangular container is employed.

Another disadvantage of the known solution involving a rectangular container is that the transformer, or more generally the electrical element, is completely submerged in the resin solution. If a large part of the transformer's surface is encapsulated, its capacity to dissipate heat is inhibited which could result in the transformer overheating. This in turn could result in a shorter service life, malfunctioning or even failure of the transformer.

The invention is primarily intended to produce an installation kit to make an electrical element watertight, and a method for the watertight installation of an electrical element, in which the risk that the installation would have to be repeated because the container has overturned would be considerably reduced, if not eliminated.

By using less resin the invention also aims to achieve a more cost effective and environmentally friendly installation of this type of electrical elements. The invention also aims to prevent the resin from overflowing from the container.

The invention is intended to achieve the watertight installation of an electrical element in which the electrical element can continue to dissipate sufficient heat into the environment, for instance into the soil in which it is installed.

### Summary of the Invention

The invention relates primarily to an installation kit for making an electrical element watertight. The installation kit comprises a container suitable to contain a sealing compound for submerging the electrical element in order to make it watertight, and wherein the container comprises a basic section for holding the electrical element and at least two protuberances along opposing sides of the basic section for holding wiring to the electrical element such that the basic section and protuberances provide a stable base for the container.

The fact that the container has the specific shape of a basic section with at least two protuberances along opposing sides of it, means that unnecessary spaces are eliminated and a base is created that considerably enhances the container's stability. As a result the amount of sealing compound required to make the electrical element watertight and the risk of overturning during installation or hardening of the sealing solution, e.g. a two component resin, gel, epoxy, rubber, etc., is drastically reduced.

An optional version of the installation kit comprises a container with visual indication of the required sealing compound volume.

Adding an indication to the inside of the container, for example a graduation to indicate how much material needs to be poured into the container, prevents material overflow when the electrical element is inserted in the basic section. Moreover, the electrical element will be encapsulated up to the desired height in this sealing compound thus reducing the risk of overheating whilst ensuring that the electrical element is fully watertight when installed. The graduation mark also indicates the desired amount of sealing compound. If less sealing compound is poured into the container the water tightness of the electrical element may be compromised.

In an optional version of the installation kit the height of the container is lower than that of the electrical element.

If the container is lower than the electrical element the outside of the electrical element will not be completely encapsulated by the sealing compound. Once this material has hardened, the electrical element can be installed in its entirety encapsulated in the hard material and protected by the container, while the heat will still be able to dissipate successfully thereby reducing the risk of overheating, malfunctioning, a shorter service life and/or failure of the electrical element. Obviously the non encapsulated section will facilitate heat dissipation, for example in applications whereby the electrical element is below ground.

When the electrical element is placed in the container with sealing compound, the compound will penetrate via the openings in the electrical elements housing. Where a container is used which is lower than the electrical element and the amount of material required to encapsulate the electrical element is minimised, it prevents too much sealing compound entering the electrical elements housing and encapsulating electrical components inside the electrical element, which might otherwise be damaged.

An optional version of the installation kit comprises a container made of polycarbonate.

In this version the container will be coloured. The colour can be selected to suit the manufacturer's requirements.

Another optional version of the installation kit comprises a container made of a transparent material.

When the container is transparent the graduation mark remains visible on the outside when the sealing compound is poured into the container so that the installer can ensure that the container is not overfilled. The transparent container ensures that the electrical element is encapsulated up to the desired height and that heat can continue to dissipate whilst no material is spilled during installation.

In another optional version of the installation kit the basic section of the container is adapted to the contours of the electrical element.

When the contours of the electrical element, e.g. a transformer or power supply unit, are square, rectangular, cylinder or diamond shaped, the basic section of the container can be adapted to suit, which further minimises the use of sealing compound.

One specific version of the installation kit has at least two protuberances at the same height and along opposing sides of the basic section to accommodate the wiring.

In this version the base of the container is cross shaped and consequently offers improved stability compared to a traditional rectangular container.

On another version of the installation kit the minimum two protuberances housing the wiring are located at different heights and along opposing sides of the basic section.

In this version the base of the container will, for example, be S shaped producing even better stability when placed upright during installation.

Yet another version of the installation kit not only contains a container but also an amount of sealing compound.

In one version of the installation kit the waterproof sealing compound is a two component resin.

The sealing compound is preferably a two component resin which, once the 2 components have been combined, can be poured into the container in liquid form. This hardens once the electrical element has been inserted in order to make the electrical element watertight. Alternative sealing compounds include rubber, polyester, gel, epoxy, elastomer, silicon, etc.

In yet another version the installation kit also comprises a packaging unit containing an insert with cut-out in which the container can be placed upright.

Thus, the installation kit can be equipped with a special box with insert. The insert has a cut-out, or a cut-out can be made, to accommodate the container. The risk of toppling over is drastically reduced if the container is placed in the cut-out during installation. In other words the packaging of the installation kit will prevent resin spills during pouring and will ensure that the container remains upright during installation and hardening of the resin. The packaging unit with insert and cut-out can be produced at little cost, for example from cardboard, making it recyclable and environmentally friendly.

By preferably using a sealing compound in liquid form, which hardens after a specific period of time, a minimum distance between the walls of the container and the electrical element will still guarantee that this material encapsulates and thus makes all the components of the electrical element watertight.

Secondly, the present invention comprises a method for the watertight installation of an electrical element, the method comprises the following steps:
- upright placing of a container, the container comprises a basic section for holding the electrical element and at least two protuberances along opposing sides of the basic section for holding wiring to the electrical element;
- filling the container with a sealing compound up to a visual indicator on the container;
- partly submerging the electrical element in the sealing compound by placing the electrical element in the basic section of the container; and
- hardening of the sealing compound.

In an optional version of the invention method a packaging unit, equipped with an insert with cut-out in which the container can be placed upright, is used when placing the container.

### Brief description of the drawings

Figure 1 illustrates a first embodiment of the installation kit according to the present invention;
Figure 2 illustrates a second embodiment of the installation kit according to the present invention;
Figures 3-9 illustrate the watertight installation method (sequence) of the invention, which uses a third embodiment of the installation kit according to the present invention; and
Figure 10 shows the container of the third embodiment in detail.

### Description

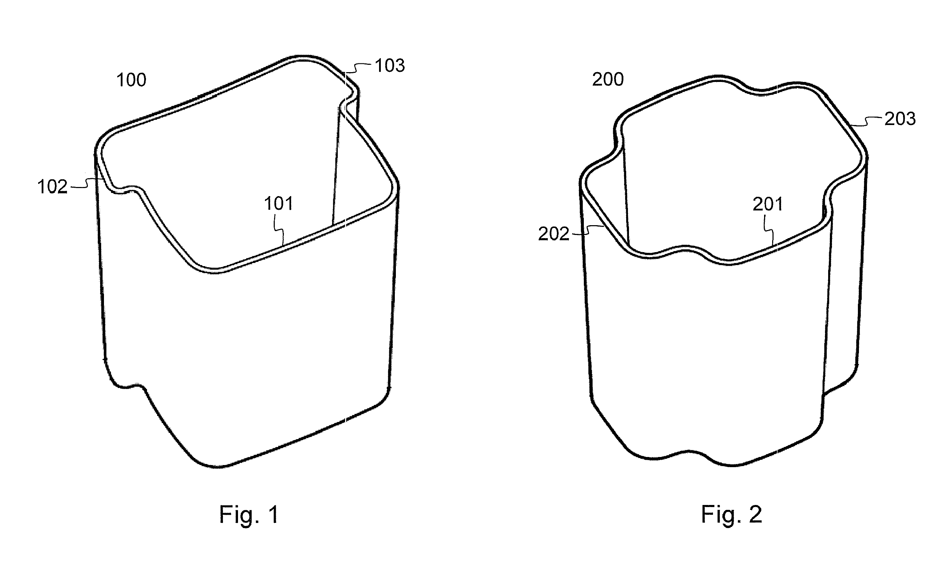

Figure 1 shows a container 100. The container 100 has a basic section 101, the shape and dimensions of which have been adapted to the contours of an electrical element, e.g. a transformer or power supply unit, which has to be made watertight. The container 100 is also equipped with two protuberances 102 and 103 in which the wiring to the electrical element can be accommodated. Protuberances 102 and 103 are located at opposing sides of the basic section 101, at the same height. Container 100 has a T shaped base which makes it stable and keeps it upright during installation of the electrical element. A waterproof sealing compound, e.g. a two component resin, is injected into the container 100. The electrical element is then inserted into the basic section 101 so that the wiring to/from the electrical element is accommodated in protuberances 102 and 103. The sealing compound will then harden and the electrical element will become fully watertight.

Figure 2 illustrates an alternative container 200 for the invention which also consists of a basic section 201 and two protuberances 202 and 203. Protuberances 202 and 203 are located at opposing sides of the basic section 201, in the middle of the sides so that the container 200 has a cross shaped base. This cross shaped base again provides increased stability for the container 200 whilst the electrical element is installed and made watertight. A sealing compound is brought into the container 200. The electrical element is then inserted into the basic section 201 so that the wiring to/from the electrical element is accommodated in protuberances 202 and 203.

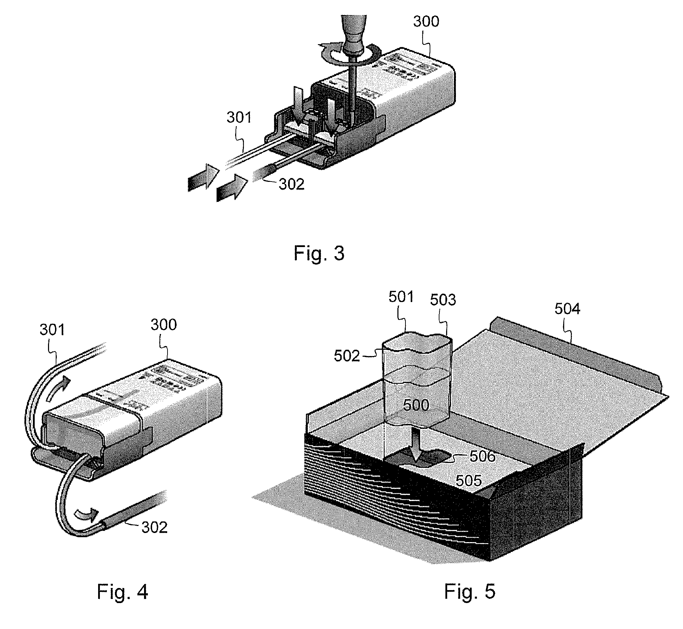

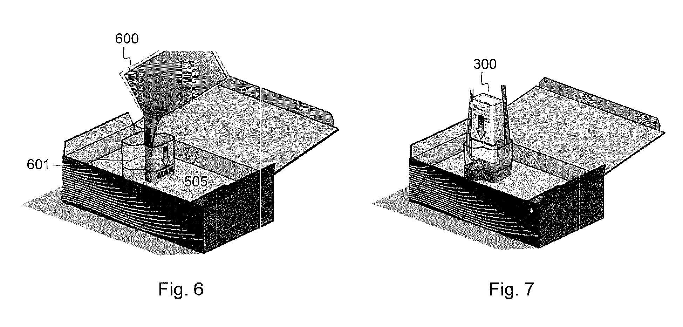

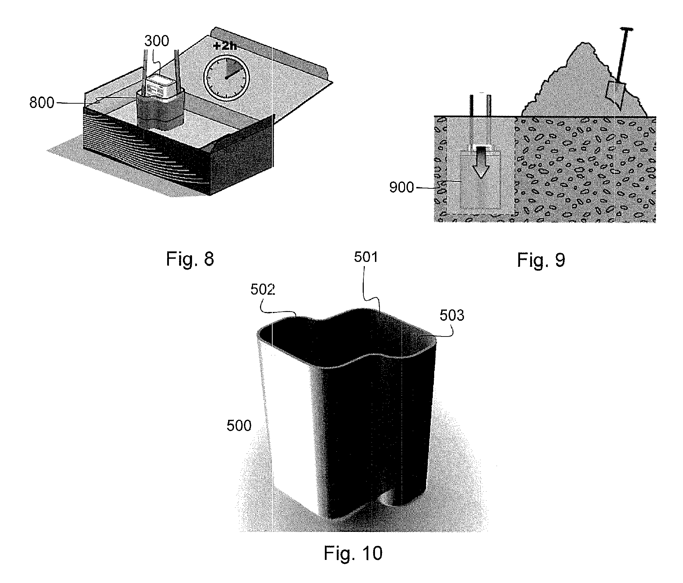

Figures 3-9 illustrate the sequential steps of the invention method for the watertight installation of transformer 300. In the first step which is shown in figure 3, wiring 301 and 302 are connected to the transformer 300. This is done by the installer e.g. using a screwdriver. This step is optional and only necessary if the wiring to the transformer 300, or more generally to the electrical element, was not already connected. In the second step, shown in figure 4, wiring 301 and 302 is shaped in such a way that both transformer 300 and wiring 301 and 302 can easily be placed in the container 500. In the case of transformer 300 this means that wiring 301 to the primary is folded up and wiring 302 to the secondary is folded against transformer 300. In the third step illustrated in figure 5, the container 500 with an S shaped base is placed upright in the cut-out 506 which is foreseen in insert 505 of packaging 504. The container 500 consists of a basic section 501, which has been adapted to the contours of transformer 300, and two protuberances 502 and 503 to accommodate wiring 301 and 302 respectively. The container 500 is pushed into cut-out 506 until the base of the container 500 touches the base of the packaging 504 and is standing upright and totally stable. In a fourth step illustrated in figure 6, the container 500 is filled with resin 600 up to the graduation mark 601 on the container 500. The resin 600 is assumed to be included with the container 500 in the packaging 504, and is in this case an integral part of the installation kit. In an alternative version of the invention the resin could be supplied or purchased separately and would consequently not be a part of the installation kit. In the fifth step as shown in figure 7, the transformer 300 is lowered into the basic section 501 of the container 500. This should be done in such a way that the connections of wiring 301 and 302 to the transformer 300 are at the bottom of the container 500, submerged in resin, and wiring 301 and 302 flying leads should exit the container 500 via protuberances 502 and 503. The graduation mark 601 was applied to prevent resin overflow from the container 500 when the transformer 300 is placed in the basic section 501 of the container 500. This is illustrated by level 800 in figure 8. The container 500 is not as high as the transformer 300 so that part of the housing of the transformer 300 reaches above the container 500 and the top level 800 of the resin 600. This ensures that heat can continue to dissipate from the transformer 300 into the environment. Figure 8 also indicates that the resin has to harden for a specific period, i.e. two hours. Afterwards, the entire unit 900 consisting of the container, resin, transformer and wiring, can be installed below ground as indicated in figure 9.

Finally, figure 10 again shows the container 500 in detail with the basic section 501 for the electrical element and protuberances 502 and 503 for the wiring, which give the container a stable, S shaped base.

This invention is by no means limited to the versions described in the examples and figures. It should also be understood that all individual features described in one version do not necessarily have to be combined in alternative versions of the invention.

## Claims

1. An installation kit for making an electrical element (300) watertight, the installation kit comprises a container (100, 200, 500) suitable to contain a sealing compound (600) for submerging the electrical element (300), **characterized in that** the container (100, 200, 500) comprises a basic section (101, 201, 501) for holding the electrical element (300), and at least two protuberances (102, 103; 202, 203; 502, 503) along opposing sides of the basic section (101, 201, 501) for holding wiring (301, 302) to the electrical element (300), such that the basic section (101, 201, 501) and protuberances (102, 103; 202, 203; 502, 503) provide a stable base for the container (100, 200, 500).

2. An installation kit according to claim 1, **characterized in that** the container (100, 200, 500) comprises a visual indicator (601) for the volume of sealing compound (600).

3. An installation kit according to claims 1 or 2, **characterized in that** the height of the container (100, 200, 500) is lower than that of the electrical element (300).

4. An installation kit according to any of the claims 1 to 3, **characterized in that** the container (100, 200, 500) is made of polycarbonate.

5. An installation kit according to any of the claims 1 to 4, **characterized in that** the container (100, 200, 500) is made of transparent material.

6. An installation kit according to any of the claims 1 to 5, **characterized in that** the basic section of the container (100, 200, 500) is adapted to the contours of the electrical element (300).

7. An installation kit according to any of the claims 1 to 6, **characterized in that** the at least two protuberances (102, 103; 202, 203) for holding the wiring are located at the same height and along opposing sides of the basic section (101, 201).

8. An installation kit according to any of the claims 1 to 6, **characterized in that** the at least two protuberances (502, 503) for holding the wiring (301, 302) are located at different heights and along opposing sides of the basic section (501).

9. An installation kit according to any of the claims 1 to 8, **characterized in that** the installation kit further comprises a volume of sealing compound (600).

10. An installation kit according to claim 9, **characterized in that** the volume of sealing compound (600) is a two component resin.

11. An installation kit according to any of the claims 1 to 10, **characterized in that** the installation kit further comprises a packaging unit (504) having an insert (505) with a cut-out (506) for placing the container (100, 200, 500) in an upright position.

12. A method for the watertight installation of an electrical element (300), the method comprises the following steps:
- upright placing of a container (100, 200, 500), the container (100, 200, 500) comprises a basic section (101, 201, 501) for holding the electrical element (300), and at least two protuberances (102, 103; 202, 203; 502, 503) along opposing sides of the basic section (101, 201, 501) for holding wiring (301, 302) to the electrical element (300),
- filling the container (100, 200, 500) with a sealing compound (600) up to a visual indicator (601) on the container (100, 200, 500);
- partly submerging the electrical element (300) in the sealing compound (600) by placing the electrical element (300) in the basic section (101, 201, 501) of the container (100, 200, 500); and
- hardening of the sealing compound (600).

13. A method according to claim 12, **characterized in that** for the step of upright placing of the container (100, 200, 500) a packaging unit (504) is used having an insert (505) with cut-out (506) in which the container (100, 200, 500) can be placed upright.
